# EUROPÄISCHE PATENTSCHRIFT

(11) **EP 0 903 587 B1**
(45) Veröffentlichungstag und Bekanntmachung des Hinweises auf die Patenterteilung: **02.11.2005**
(21) Anmeldenummer: 98115905.6
(22) Anmeldetag: 24.08.1998
(51) Int. Cl.: G01R 31/3185

(54) **Verfahren zum Testen einer elektronischen Schaltung**
Test method for an electronic circuit
Procédé de test d'un circuit électronique

(30) Priorität: 18.09.1997 DE 19741212
(43) Veröffentlichungstag der Anmeldung: 24.03.1999
(73) Patentinhaber: Infineon Technologies AG, 81669 München (DE)
(72) Erfinder: Kock, Ernst-Josef, 85614 Kirchseeon (DE); Schneider, Peter, 80333 München (DE)
(74) Vertreter: Jannig, Peter

(56) Entgegenhaltungen:
- EP-A- 0 356 538
- US-A- 5 271 019

## Beschreibung

Die vorliegende Erfindung betrifft ein Verfahren gemäß dem Oberbegriff des Patentanspruchs 1.

Ein derartiges Verfahren ist das insbesondere zum Testen integrierter Schaltungen verwendete sogenannte Scan-Verfahren.

Die Schaltungen, die nach dem Scan-Verfahren getestet werden können sollen, müssen in eine Scan-Betriebsart versetzbar sein, in welcher ausgewählte Schaltungsteile wie beispielsweise alle Flip-Flops der Schaltung so verschaltet sind, daß sie durch eine außerhalb der zu testenden Schaltung vorgesehene Testeinrichtung individuell in bestimmte Anfangszustände versetzbar sind und daß deren aktueller Zustand bei Bedarf durch die Testeinrichtung ausgelesen werden kann. Dies kann im Fall der Verwendung von Flip-Flops als ausgewählte Schaltungsteile dadurch erreicht werden, daß die Flip-Flops in der Scan-Betriebsart in Reihe hintereinandergeschaltet sind, wobei der Eingangsanschluß eines jeweiligen Flip-Flops mit dem Ausgangsanschluß des in der Reihe vor ihm stehenden Flip-Flops verbunden ist, und wobei der Ausgangsanschluß eines jeweiligen Flip-Flops mit dem Eingangsanschluß des in der Reihe nach ihm kommenden Flip-Flops verbunden ist. Eine derartige Anordnung wird auch als Scan-Kette bezeichnet.

Eine solche Scan-Kette, genauer gesagt deren im betrachteten Beispiel durch Flip-Flops gebildeten Elemente können relativ einfach initialisiert werden. Ein an den Eingangsanschluß des ersten Flip-Flops der Scan-Kette angelegtes Signal, genauer gesagt der sich im Ansprechen darauf einstellende Zustand des betreffenden Flip-Flops wird nämlich mit dem Takt eines an die Flip-Flops angelegten Taktsignals von Flip-Flop zu Flip-Flop weitergeschoben; jedes Flip-Flop der Scan-Kette nimmt mit jedem Taktimpuls den Zustand des in der Scan-Kette vor ihm stehenden Flip-Flops an.

Soll das x-te Flip-Flop der Scan-Kette in den Zustand A versetzt werden, so muß "nur" an den Eingangsanschluß des ersten Flip-Flops der Scan-Kette ein Signal angelegt werden, durch welches dieses Flip-Flop und die nachgeschalteten Flip-Flops in den Zustand A versetzbar sind, und die Scan-Kette (alle Flip-Flops derselben) mit x Taktimpulsen beaufschlagt werden.

Umgekehrt können am letzten Flip-Flop der Scan-Kette die Zustände der einzelnen Flip-Flops zu einem bestimmten Zeitpunkt sequentiell ausgelesen werden.

Enthält die Scan-Kette n Flip-Flops, so läuft der Test der Schaltung nach dem Scan-Verfahren wie folgt ab: Zunächst wird die Schaltung in die Scan-Betriebsart versetzt, wodurch sich die erwähnte Scan-Kette bildet. Diese Scan-Kette wird durch sequentielles Anlegen von n Eingangssignalen und n Taktimpulsen in einen definierten Anfangszustand versetzt. Danach wird die Schaltung in eine Normal-Betriebsart versetzt; die Scan-Betriebsart wird hierzu verlassen, die Scan-Kette (die Reihenschaltung der Flip-Flops) aufgelöst. In der Normal-Betriebsart wird die Schaltung kurzzeitig testweise normal betrieben. Die Dauer, während welcher die Schaltung normal betrieben wird, wird vorzugsweise durch eine Anzahl von Taktzyklen definiert. Diese Anzahl von Taktzyklen ist vorzugsweise sehr klein (beispielsweise 1). In der Zeit, während welcher die Schaltung normal betrieben wird, verändern sich zumindest teilweise die Zustände der anfänglich initialisierten Flip-Flops, wobei es sich aus der bestimmungsgemäßen Funktion der zu testenden Schaltung ermitteln läßt, in welchem (Soll-)Zustand die Flip-Flops sich zu einem jeweiligen Zeitpunkt befinden müßten. Nachdem die Schaltung eine vorbestimmte Anzahl von Taktzyklen normal betrieben wurde, wird sie in die Scan-Betriebsart zurückversetzt, wodurch die Flip-Flops wieder zur Scan-Kette verschaltet werden. Werden die so verschalteten Flip-Flops in diesem Zustand mit Taktsignalen beaufschlagt, so werden am Ende der Scan-Kette (aus dem Ausgangsanschluß des letzten Flip-Flops der Scan-Kette) sequentiell im Takt der Taktsignale Daten herausgeschoben, welche den (Ist-)Zustand der Flip-Flops der Scan-Kette zum Zeitpunkt des Endes des Normal-Betriebs repräsentieren. Vergleicht man sodann den wie beschrieben ermittelten Ist-Zustand der Flip-Flops der Scan-Kette mit dem bekannten Soll-Zustand derselben, so läßt sich daran ersehen, ob die zu testende Schaltung fehlerfrei läuft oder nicht.

Derart oder ähnlich funktionierende Tests ermöglichen es auf relativ einfache Weise, selbst sehr komplexe Schaltungen innerhalb von sehr kurzer Zeit umfassend zu testen. Allerdings zeigt die Erfahrung, daß es unter ungünstigen Bedingungen vorkommen kann, daß ordnungsgemäß funktionierende Schaltungen als fehlerhaft eingestuft werden. Dies ist verständlicherweise ein Nachteil, den es zu beseitigen gilt.

Weitere Verfahren zum Testen einer elektronischen Schaltung sind in der US 5 271 019 A und der EP 0 356 538 A beschrieben.

Der vorliegenden Erfindung liegt daher die Aufgabe zugrunde, das Verfahren gemäß dem Oberbegriff des Patentanspruchs 1 derart weiterzubilden, daß dadurch nur fehlerhafte Schaltungen als fehlerhaft eingestuft werden.

Diese Aufgabe wird erfindungsgemäß durch das in Patentanspruch 1 beanspruchte Verfahren gelöst.

Ein bestimmungsgemäßes Zusammenwirken von kooperierenden Schaltungsteilen, welches beispielsweise die Flip-Flops, aber auch andere und/oder umfassendere Komponenten der zu testenden Schaltung sein können, ist unter anderem dann nicht zu erwarten, wenn die Taktsignale, mit denen die einzelnen Schaltungsteile zu takten sind, beim testweisen Betrieb während des Schaltungstests einen zu großen gegenseitigen Versatz bzw. Taktskew aufweisen. Dies ist in der Regel besonders ausgeprägt, wenn die Taktsignale durch verschiedene Taktsignalgeneratoren erzeugt werden.

Diese und sonstige Unzulänglichkeiten im Zusammenwirken von Schaltungsteilen können vermieden werden, wenn Schaltungsteile, die bei der testweisen Inbetriebnahme während des Schaltungstests nicht oder möglicherweise nicht bestimmungsgemäß zusammenwirken, nicht gleichzeitig in Betrieb genommen werden.

Die nicht in Betrieb genommenen Schaltungsteile werden vorzugsweise "nur" nicht mit Taktsignalen versorgt.

Bei einem solchen Teil-Betrieb der Schaltung erhält man stets exakt reproduzierbare Ergebnisse (Schaltungsteil-Zustände); daß die interessierenden und der Auswertung des Tests zugrundegelegten Zustände der Schaltungsteile (der Elemente einer Scan-Kette) zufallsbedingt variieren können, ist dadurch zuverlässig ausgeschlossen.

Aus der Tatsache, daß bestimmte Schaltungsteile während des Schaltungstests nicht bestimmungsgemäß zusammenwirken, kann nicht gefolgert werden, daß die Schaltung fehlerhaft ist; es sind lediglich die besonderen Umstände der testweisen Inbetriebnahme der Schaltung, insbesondere die außergewöhnliche und nur äußerst kurzzeitige Inbetriebnahme, die bestimmte Schaltungsteile nicht bestimmungsgemäß zusammenwirken lassen.

Der Vergleich der Soll-Zustände der in Betrieb gesetzten Schaltungsteile und der Ist-Zustände derselben läßt folglich mit an Sicherheit grenzender Wahrscheinlichkeit zutreffende Schlußfolgerungen über die Fehlerfreiheit bzw. Fehlerhaftigkeit der zu testenden Schaltung zu. Insbesondere ist es im wesentlichen ausgeschlossen, daß fehlerfrei arbeitende Schaltungen als fehlerhaft eingestuft werden.

Vorteilhafte Weiterbildungen der Erfindung sind Gegenstand der Unteransprüche.

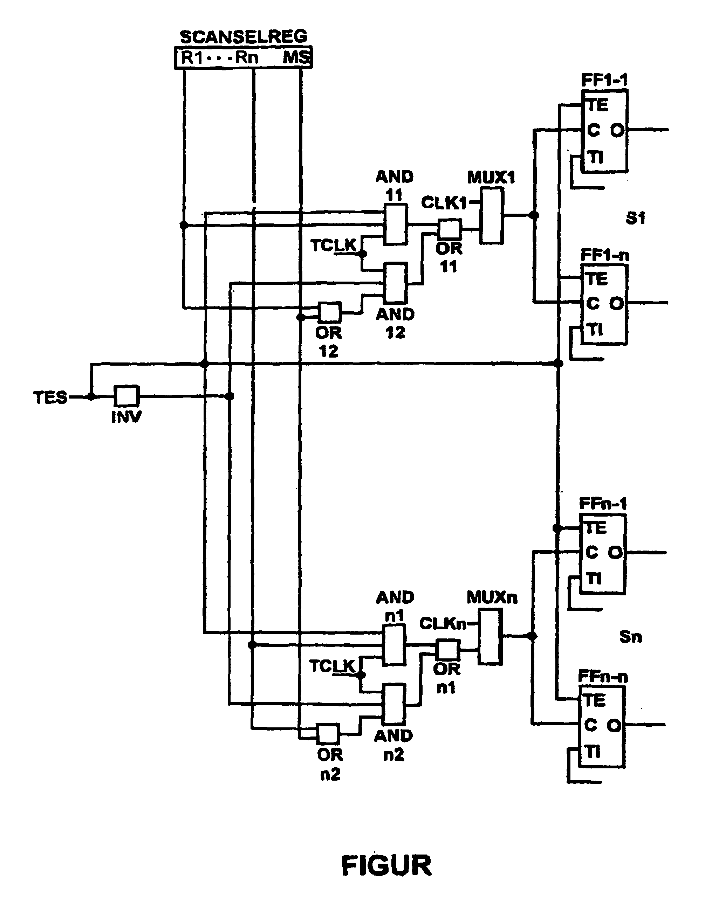

Die Erfindung wird nachfolgend anhand eines Ausführungsbeispiels unter Bezugnahme auf die Zeichnung näher beschrieben.

Die Figur zeigt den Aufbau einer Schaltung, welche dazu ausgelegt ist, daß bei Bedarf selektiv nur bestimmte Schaltungsteile in Betrieb gesetzt werden.

Die Schaltung, die es durch das nachstehend näher beschriebene Verfahren und die nachstehend näher beschriebene Vorrichtung zu testen gilt, ist eine integrierte Logikschaltung. Das Verfahren und die Vorrichtung können jedoch auch nichtintegrierte Schaltungen und/oder andere Schaltungen als Logikschaltungen getestet werden.

Das Verfahren und die Vorrichtung dienen insbesondere dazu, die Schaltungen beim Hersteller vor deren Auslieferung zu testen. Nichtsdestotrotz können das Verfahren und die Vorrichtung auch für eine beliebig später und anderswo durchzuführende Überprüfung zum Einsatz kommen.

Das Verfahren, unter Verwendung dessen die zu testende Schaltung getestet wird, ist ein Scan-Verfahren, wobei die Elemente der Scan-Kette die Flip-Flops der zu testenden Schaltung sind. Als Elemente der Scan-Kette können jedoch auch andere Schaltungsteile als Flip-Flops verwendet werden.

Der Test der Schaltung läuft in vier Stufen ab, nämlich
1) Versetzen der Flip-Flops (oder die anderen Schaltungsteile) in einen bestimmten Anfangszustand,
2) kurzzeitige testweise Inbetriebnahme der Schaltung,
3) Auslesen der Zustände der Flip-Flops, und
4) Vergleich der Ist-Zustände der Flip-Flops mit deren Soll-Zuständen
und stimmt insoweit mit dem eingangs beschriebenen Scan-Verfahren überein.

Zur Durchführung der Stufe 1 wird die zu testende Schaltung in eine Scan-Betriebsart versetzt, in welcher die Flip-Flops in einer oder mehreren Scan-Ketten hintereinandergeschaltet sind.

Das Vorsehen mehrerer Scan-Ketten erweist sich als vorteilhaft, weil dadurch eine einfachere, zuverlässigere und schnellere Initialisierung der Scan-Ketten-Elemente möglich ist. Für eine ordnungsgemäße Initialisierung einer jeweiligen Scan-Kette ist es nämlich unter anderem erforderlich, daß die Taktimpulse, durch welche die jeweiligen Scan-Ketten-Elemente getaktet werden, die jeweiligen Scan-Ketten-Elemente innerhalb vorbestimmter Zeitspannen erreichen, denn anderenfalls kann es passieren, daß sich die Zeiten, zu denen die Scan-Ketten-Elemente zur Entgegennahme von Daten bereit sind, nicht mit den Zeiten überschneiden, zu denen neue Daten an die betreffenden Scan-Ketten-Elemente angelegt werden und/oder daß sich die Zeiten, zu denen die Scan-Ketten-Elemente veränderte Daten ausgeben, nicht mit den Zeiten überschneiden, zu denen das diese Daten empfangende Scan-Ketten-Element zur Entgegennahme von Daten bereit ist. Dies ist insbesondere dann nicht gewährleistet, wenn die Taktimpulse unterschiedlich lange Laufzeiten vom Taktgenerator zu den Scan-Ketten-Elementen haben oder wenn die Taktimpulse von mehreren Taktgeneratoren erzeugt werden, die nicht exakt gleichzeitig angestoßen und/oder gleichlaufend betrieben werden können oder wenn die Signale, die zwischen hintereinandergeschalteten Scan-Ketten-Elementen zu übertragen sind, außergewöhnlich lange oder kurze Laufzeiten aufweisen. Verteilt man die Flip-Flops der zu testenden Schaltung hingegen auf mehrere Scan-Ketten und achtet bei der Verteilung der Scan-Ketten-Elemente auf die jeweiligen Scan-Ketten und/oder bei der Festlegung der Reihenfolge innerhalb der Scan-Kette darauf, daß alle Elemente einer jeweiligen Scan-Kette ordnungsgemäß getaktet werden, so kann zuverlässig sichergestellt werden, daß sämtliche Scan-Ketten-Elemente wunschgemäß initialisiert werden können. Die Taktimpulse, durch welche die Scan-Ketten-Elemente getaktet werden, können auch spezielle Test-Taktimpulse sein. Auch in diesem Fall erweist sich das Vorsehen mehrerer Scan-Ketten als vorteilhaft, weil auch hier insbesondere laufzeitbedingt nicht sichergestellt ist, daß die Scan-Ketten-Elemente genau dann zum Empfangen und Ausgeben von Daten bereit sind, wenn es von Ihnen erwartet wird. Von den mehreren Scan-Ketten wird jede für sich geladen; bereits geladene (initialisierte) Scan-Ketten dürfen nach dem Laden nicht mehr mit Taktimpulsen beaufschlagt werden, weil sie dadurch wieder ent- bzw. umgeladen werden würden. Die Anzahl der Elemente pro Scan-Kette ist keinen Einschränkungen unterworfen; die Scan-Ketten können unabhängig voneinander beliebig lang sein.

Nach der Initialisierung der Scan-Ketten-Elemente in Schritt 1 wird die zu testende Schaltung zum Verlassen der Scan-Betriebsart veranlaßt, wodurch die Hintereinanderschaltung der Scan-Ketten-Elemente aufgehoben wird und die Schaltung testweise normal betrieben werden kann. Der testweise Normalbetrieb unterscheidet sich erheblich von dem herkömmlicher Test-Verfahren. Es wird nämlich nicht etwa die gesamte Schaltung auf einmal, sondern jeweils nur ein ausgewählter Teil derselben in Betrieb genommen. Darüber hinaus, aber völlig unabhängig hiervon wird zumindest zum Takten der Scan-Ketten-Elemente ein spezielles Test-Taktsignal verwendet.

Die Schaltungsteile, die jeweils gleichzeitig in Betrieb genommen werden, sind oder enthalten jeweils nur solche Scan-Ketten-Elemente, die ordnungsgemäß zusammenwirken (dann zum Datenempfang bereit sind, wenn Daten ankommen bzw. dann Daten ausgeben, wenn der Empfänger zum Empfang bereit ist). Diese Vorgehensweise ermöglicht es, den jeweils aktuellen Zustand der Scan-Ketten-Elemente zuverlässig vorherzusagen, wodurch der in Schritt 4 durchgeführte Vergleich des in Schritt 3 ermittelten Ist-Zustandes der Scan-Ketten-Elemente mit einem theoretisch oder empirisch ermittelten Soll-Zustand eine zuverlässige Aussage über die Fehlerhaftigkeit bzw. Fehlerfreiheit der zu testenden Schaltung zuläßt. Die Schritte 3 und 4 lassen sich besonders einfach und schnell durchführen, wenn die gleichzeitig betriebenen Schaltungsteile jeweils sämtliche Elemente einer oder mehrerer Scan-Ketten beinhalten.

Der Aufbau einer möglichen Anordnung zur testweisen Inbetriebnahme ausgewählter Schaltungsteile ist in der Figur dargestellt. Wie aus den nachstehenden Erläuterungen ersichtlich ist, kann die gezeigte Anordnung auch zur Initialisierung der Scan-Ketten-Elemente (Schritt 1 des Schaltungstests) und zum Auslesen der aktuellen Zustände derselben (Schritt 3 des Schaltungstests) verwendet werden; hierauf wird in der Beschreibung jedoch nur am Rande eingegangen.

Die in der Figur dargestellte Anordnung zeigt von der zu testenden Schaltung nur einige Scan-Ketten-Elemente, genauer gesagt Flip-Flops FF1-1 bis FF1-n einer ersten Scan-Kette S1 und Flip-Flops FFn-1 bis FFn-n einer n-ten Scan-Kette Sn. Jedes der Flip-Flops weist einen Taktsignal-Eingangsanschluß C, einen Betriebsartwahlanschluß TE, einen Test-Eingangsanschluß TI, einen nicht gezeigten Normal-Eingangsanschluß und einen Ausgangsanschluß O auf. Die Taktsignal-Eingangsanschlüsse C der Flip-Flops einer jeweiligen Scan-Kette sind jeweils mit dem Ausgangsanschluß eines Multiplexers verbunden. D.h., die Taktsignal-Eingangsanschlüsse C der Flip-Flops FF1-1 bis FF1-n der ersten Scan-Kette S1 sind mit dem Multiplexer MUX1, und die Taktsignal-Eingangsanschlüsse C der Flip-Flops FFn-1 bis FFn-n der n-ten Scan-Kette Sn sind mit dem Multiplexer MUXn verbunden. Die Multiplexer weisen zwei Eingangsanschlüsse auf, wobei an einem der Eingangsanschlüsse dasjenige Taktsignal anliegt, mit welchem die jeweiligen Flip-Flops während des normalen Betriebes getaktet werden (CLK1 bei MUX1 und CLKn bei MUXn), und wobei dem jeweils anderen der Eingangsanschlüsse der Multiplexer jeweils eine aus zwei UND-Gliedern AND11 und AND12 bzw. ANDn1 und ANDn2 und zwei ODER-Gliedern OR11 und OR12 bzw. ORn1 und ORn2 bestehende Logikschaltung vorgeschaltet ist, welche mit einem Betriebsartwahlsignal TES, mit dem Inhalt eines Scan-Ketten-Auswahlregister SCANSELREG (mit den Inhalten von Registerelementen R1 bis Rn und MS) und einem Test-Taktsignal TCLK beaufschlagt wird.

Das Betriebsartwahlsignal TES ist aktiv, wenn und so lange die Schritte 1 und 3 des Schaltungstests ausgeführt werden; es ist inaktiv, wenn und so lange der Schritt 2 des Schaltungstests ausgeführt wird. Das Betriebsartwahlsignal TES steht auch in invertierter Form zur Verfügung, wobei die Invertierung durch einen Inverter INV bewerkstelligt wird.

Der Inhalt des Registerelements MS weist einen hohen Pegel auf, wenn bei der testweisen Inbetriebnahme der zu testenden Schaltung alle Schaltungsteile gleichzeitig in Betrieb genommen werden sollen; er weist einen niedrigen Pegel auf, wenn nur ausgewählte Schaltungsteile gleichzeitig in Betrieb genommen werden sollen.

Die Registerelemente R1 bis Rn, von welchen je eines einer bestimmten Scan-Kette, genauer gesagt das Element R1 der Scan-Kette S1, ein Element R2 einer Scan-Kette S2, ..., und das Element Rn der Scan-Kette Sn zugeordnet ist, legen (bei niedrigem Pegel des Registerelements MS) fest, welche der Schaltungsteile der zu testenden Schaltung bei der testweisen Inbetriebnahme gleichzeitig in Betrieb genommen werden.

Die zu testende Schaltung wird durch das Betriebsartwahlsignal TES in die Scan-Betriebsart versetzt. Das Versetzen der Schaltung in die Scan-Betriebsart (zur Durchführung der Schritte 1 und 3 des Schaltungstests), daß die Flip-Flops FF1-1 bis FFn-n jeweils den Test-Eingangssignalanschluß TI als Eingangsanschluß verwenden (den Normal-Eingangsanschluß abschalten oder ignorieren), wodurch die Flip-Flops der jeweiligen Scan-Ketten in Reihe hintereinandergeschaltet werden. Anderseits werden durch die jeweiligen Multiplexer nicht mehr die normalen Taktsignale CLK1 bzw. CLKn zu den Taktsignal-Eingangsanschlüssen C der Flip-Flops durchgeschaltet, sondern die jeweiligen Ausgangssignale der den anderen Multiplexer-Eingangsanschlüssen vorgeschalteten Logikschaltungen; dies ist übrigens auch bei der testweisen Inbetriebnahme der zu testenden Schaltung in Schritt 2 des Schaltungstests der Fall.

Die jeweiligen Logikschaltungen schalten das Test-Taktsignal TCLK auf den zweiten Multiplexer-Eingangsanschluß durch, wenn entweder
- das Betriebsartwahlsignal TES aktiv ist und das der betreffenden Scan-Kette zugeordnete Registerelement Rx des Scan-Ketten-Auswahlregisters SCANSELREG hohen Pegel aufweist, oder
- das Betriebsartwahlsignal TES inaktiv ist und das Registerelement MS und/oder das der betreffenden Scan-Kette zugeordnete Registerelement Rx des Scan-Ketten-Auswahlregisters SCANSELREG hohen Pegel aufweist.

In allen anderen Fällen wird das Test-Taktsignal TCLK nicht durchgeschaltet.

Aus den vorstehenden Erläuterungen ist ersichtlich, daß durch das Scan-Ketten-Auswahlregister SCANSELREG festgelegt wird, ob eine vollständige oder nur teilweise testweise Inbetriebnahme der zu testenden Schaltung erfolgen soll, und welche Schaltungsteile bei einer nur teilweisen Inbetriebnahme der Schaltung zu einem jeweiligen Zeitpunkt in Betrieb genommen werden sollen.

Welches die Schaltungsteile sind, die zu einem jeweiligen Zeitpunkt gleichzeitig in Betrieb genommen werden können, wird vorzugsweise nach dem erfolgten Layout der zu testenden Schaltung unter Berücksichtigung des zu erwartenden Taktskew und der zu erwartenden Datenlaufzeiten zwischen den Scan-Ketten-Elementen festgelegt. Es werden jeweils nur solche Scan-Ketten-Elemente gleichzeitig testweise in Betrieb gesetzt, bei welchen der Taktskew zwischen den einzelnen Takten kleiner ist als die kürzeste Signallaufzeit zwischen zwei Scan-Ketten-Elementen. Die Festlegung von gleichzeitig in Betrieb zu setzenden Schaltungsteilen kann alternativ oder zusätzlich auch unter Berücksichtigung anderer Bedingungen erfolgen; wichtig ist "nur", daß die Schaltungsteile unter den gegebenen Umständen (Testbedingungen) ordnungsgemäß zusammenwirken. Die Scan-Ketten-Elemente, die beim betrachteten Beispiel gleichzeitig in Betrieb genommen werden, sind jeweils sämtliche Elemente einer oder mehrerer Scan-Ketten. D.h., die Inbetriebnahme der Scan-Ketten-Elemente erfolgt in Einheiten von einer oder mehreren Scan-Ketten. Bei entsprechender Modifikation der in der Figur gezeigten Anordnung können jedoch auch beliebig ausgewählte Elemente beliebiger Scan-Ketten gemeinsam in Betrieb genommen werden.

Nachdem ausgewählte Schaltungsteile der zu testenden Schaltung in Schritt 2 des Schaltungstests testweise kurzzeitig (im betrachteten Beispiel für die Dauer eines Taktes) in Betrieb gesetzt wurden, wird die zu testende Schaltung (durch Aktivierung des Betriebsartwahlsignals TES) zur Durchführung von Schritt 3 des Schaltungstests wieder in die Scan-Betriebsart versetzt. Dadurch werden die Scan-Ketten-Elemente wieder zu den Scan-Ketten verschaltet. Dies ermöglicht es, die jeweiligen Zustände der Scan-Ketten-Elemente auszulesen. Die Scan-Ketten, genauer die Elemente einer jeweiligen Scan-Kette müssen hierzu lediglich wie beim Initialisieren der Scan-Kette getaktet werden. Dies allein reicht aus, um die Zustände der jeweiligen Scan-Ketten-Elemente bzw. diese repräsentierende Daten oder Signale sequentiell am hinteren Ende der betreffenden Scan-Kette herauszuschieben.

Am wichtigsten dürfte es in der Regel sein, diejenigen Scan-Ketten auszulesen, von welchen einzelne oder alle Elemente zuvor in Schritt 2 testweise in Betrieb genommen wurden. Es können jedoch auch diejenigen Scan-Ketten ausgelesen und dem Vergleich in Schritt 4 des Schaltungstests unterzogen werden, deren Elemente sich mangels zwischenzeitlicher Inbetriebnahme zustandsmäßig nicht verändert haben dürfen.

Gleichzeitig mit dem Auslesen der Zustände der Scan-Ketten-Elemente können diese wie in Schritt 1 neu initialisiert werden. Dies erweist sich als vorteilhaft, weil die Schritte 1 bis 4 des Schaltungstests bei nur teilweiser testweiser Inbetriebnahme der zu testenden Schaltung so oft wiederholt werden müssen, bis alle Schaltungsteile wenigstens einmal testweise in Betrieb gesetzt waren und dadurch einer Überprüfung unterzogen werden konnten.

Die in Schritt 3 des Schaltungstests ausgelesenen Ist-Zustände der Scan-Ketten-Elemente werden in Schritt 4 einem Vergleich mit bekannten Soll-Zuständen unterworfen.

Stimmen die Ist-Zustände mit den Soll-Zuständen überein, so kann davon ausgegangen werden, daß die der Überprüfung unterworfenen Schaltungsteile (insbesondere die Schaltungsteile, die in Schritt 2 testweise in Betrieb gesetzt wurden) den betreffenden Testdurchlauf fehlerfrei bestanden haben; anderenfalls, d.h. wenn Abweichungen zwischen den Ist-Zuständen und den Soll-Zuständen existieren, kann davon ausgegangen werden, daß die Schaltung fehlerbehaftet ist.

Mit der Abarbeitung der Schritte 1 bis 4 ist ein Durchlauf des Schaltungstests beendet. Wurden noch nicht alle Schaltungsteile getestet, müssen die Schritte 1 bis 4 bzw. 2 bis 4 für die noch nicht getesteten Schaltungsteile wiederholt werden. Zuvor muß das Scan-Ketten-Auswahlregister SCANSELREG inhaltlich modifiziert werden, und zwar derart, daß beim nächsten Durchlauf zumindest teilweise bislang noch nicht getestete Schaltungsteile getestet werden.

Bei dem beschriebenen Verfahren werden stets nur solche Schaltungsteile gemeinsam getestet, die unter den herrschenden Testbedingungen ordnungsgemäß zusammenwirken können. Dadurch ist die Gefahr, daß eine fehlerfrei aufgebaute und arbeitende Schaltung als fehlerhaft eingestuft wird, auf ein Minimum reduziert.

Die nur jeweils teilweise testweise Inbetriebnahme der zu testenden Schaltung (Schritt 2 des beschriebenen Verfahrens) erweist sich auch als vorteilhaft, wenn die Schaltungsteile anders als in Schritt 1 initialisiert werden und/oder deren Zustände anders als in Schritt 3 ausgelesen werden. Insbesondere ist es keine zwingende Voraussetzung, daß die betreffenden Elemente hierfür in Reihe zu Ketten verschaltet werden; es kann stattdessen beispielsweise vorgesehen werden, die einzelnen Elemente zum Laden und Entladen direkt anzusprechen (z.B. über einen parallelen Registertransfer).

Die nur jeweils teilweise Inbetriebnahme der zu testenden Schaltung erweist sich auch insofern als vorteilhaft, als die Anfangszustände, in die die einzelnen Schaltungsteile zu Testbeginn bzw. vor jedem Testdurchlauf zu versetzen sind (die sogenannten Testpatterns), ohne Berücksichtigung eines gegebenenfalls in der zu testenden Schaltung vorhandenen Taktskew entworfen werden können, denn dieser kann ja bei einer nur teilweisen Inbetriebnahme der zu testenden Schaltung auf einen vernachlässigbaren bzw. tolerierbaren Umfang begrenzt werden. Der Entwurf der Testpatterns wird dadurch erheblich einfacher und weniger fehleranfällig als es bisher der Fall war.

## Patentansprüche

1. Verfahren zum Testen einer elektronischen Schaltung, bei welchem der Ist-Zustand von zuvor nach einer anfänglichen Initialisierung testweise in Betrieb gesetzten schaltungsteilen mit einem Soll-Zustand verglichen wird, wobei die zu testende Schaltung zum Initialisieren und zum Ermitteln des Ist-Zustandes in eine Scan-Betriebsart versetzt wird, in welcher die Elemente (FF1-1 - FFn-n), deren Zustand es zu initialisieren bzw. auszulesen gilt, hintereinander zu einer oder mehreren Scan-Ketten (S1 - Sn) verschaltet sind,
**dadurch gekennzeichnet,**
**daß** von den zu testenden Schaltungateilen nicht alle Schaltungsteile, sondern im wesentlichen nur jeweils solche Schaltungsteile gleichzeitig betrieben werden, von denen unter den gegebenen Umständen ein bestimmungsgemäßes Zusammenwirken erwartet werden kann.

2. Verfahren nach Anspruch 1,
**dadurch gekennzeichnet,**
**daß** die Verteilung der Scan-Ketten-Elemente (FFI-1 - FFn-n) auf die verschiedenen Scan-Ketten (S1 - Sn) und/oder die Festlegung der Reihenfolge innerhalb einer Scan-Kette so erfolgt, daß Taktsignale (TCLK), durch welche die Scan-Ketten-Blemente getaktet werden, die Scan-Ketten-Elemente während des Tests spätestens zu einem Zeitpunkt erreichen, zu dem durch das jeweilige Scan-Ketten-Element Signale zu empfangen und/oder zu versenden sind.

3. Verfahren nach Anspruch 1 oder 2,
**dadurch gekennzeichnet,**
**daß** als Scan-Ketten-Elemente (FF1-1 - FFn-n) zumindest Teile von Flip-Flops der zu testenden Schaltung verwendet werden.

4. Verfahren nach einem der vorhergehenden Ansprüche,
**dadurch gekennzeichnet,**
**daß** zum Initialisieren, zur testweisen Inbetriebnahme und zum Auslesen der Zustände der zu testenden Schaltung ein spezielles Test-Taktsignal als Taktsignal (TCLK) verwendet wird.

5. Verfahren nach einem der vorhergehenden Ansprüche,
**dadurch gekennzeichnet,**
**daß** denjenigen Teilen der zu testenden Schaltung, die zum betreffenden Zeitpunkt nicht zu initialisieren, testweise in Betrieb zu setzen oder auszulesen sind, keine Taktsignale zugeführt werden.

6. Verfahren nach einem der vorhergehenden Ansprüche,
**dadurch gekennzeichnet,**
**daß** die Schaltungsteile, die selektiv in oder außer Betrieb setzbar sind, jeweils sämtliche Elemente einer oder mehrerer Scan-Ketten (S1 - Sn) umfassen.

7. Verfahren nach einem der Ansprüche 1 bis 5,
**dadurch gekennzeichnet,**
**daß** die Schaltungsteile, die selektiv in oder außer Betrieb setzbar sind, ausgewählte Teile einer oder mehrerer Scan-Ketten (S1 - Sn) umfassen.

8. Verfahren nach einem der Ansprüche 4 und 5-7, wenn auf Anspruch 4 bezogen,
**dadurch gekennzeichnet,**
**daß** es vom Inhalt von einem oder mehreren Schaltungsteilen zugeordneten Register (SCANSELREG) und dem Zustand eines Betriebsartwahlsignals (TES) abhängig gemacht wird, ob ein normales Taktsignal (TCLK1 - CLKn), das spezielle Test-Taktsignal (TCLK) oder kein Taktsignal an die betreffenden Schaltungsteile angelegt wird.

9. Verfahren nach einem der vorhergehenden Ansprüche,
**dadurch gekennzeichnet,**
**daß** zum Testen der zu testenden Schaltung mehrere Testdurchläufe durchgeführt werden, wobei bei jedem Testdurchlauf zumindest teilweise andere Schaltungsteile in Betrieb gesetzt werden.

10. Verfahren nach Anspruch 9,
**dadurch gekennzeichnet,**
**daß** so viele Testdurchläufe durchgeführt werden, daß schließlich jeder der zu testenden Schaltungsteile wenigstens einmal allein oder zusammen mit anderen Schaltungsteilen in Betrieb gesetzt war.

11. Verfahren nach Anspruch 10,
**dadurch gekennzeichnet,**
**daß** die Anfangszustände, in welche die Schaltungsteile vor jedem Durchlauf versetzt werden, bei den verschiedenen Testdurchläufen identisch sind.

12. Verfahren nach einem der Ansprüche 8 bis 11,
**dadurch gekennzeichnet,**
**daß** der Inhalt des Registers (SCANSELREG) abhängig von schaltungsspezifischen Voreinstellungen und der Nummer des Testdurchlaufs verändert wird.

## Claims

1. Method for testing an electronic circuit, in which the actual state of circuit components which have previously been activated on a test basis after an initial initialization is compared with a setpoint state, the circuit to be tested being placed in a scan mode of operation in which the elements (FF1-1-FFn-n) whose state is to be initialized and/or read out are connected one behind the other or to form one or more scan chains (S1-Sn) **characterized in that**, of the circuit components to be tested, not all but essentially only in each case those circuit components of which, under the given circumstances, interaction according to the regulations can be expected are operated simultaneously.

2. Method according to Claim 1, **characterized in that** the assignment of the scan chain elements (FF1-1-FFn-n) to the various scan chains (S1-Sn) and/or the definition of the sequence within a scan chain is carried out in such a way that clock signals (TCLK) via which the scan chain elements are clocked reach the scan chain elements during the test at the latest at a time at which signals are to be received and/or transmitted by the respective scan chain element.

3. Method according to Claim 1 or 2, **characterized in that** at least parts of the flip-flops of the circuit to be tested are used as scan chain elements (FF1-1-FFn-n).

4. Method according to one of the preceding claims, **characterized in that** a specific test clock signal is used as clock signal (TCLK) for initializing, for actuating on a test basis and for reading out the states of the circuit to be tested.

5. Method according to one of the preceding claims, **characterized in that** no clock signals are fed to those parts of the circuit to be tested which, at the relevant time, are not to be initialized, activated on a test basis or read out.

6. Method according to one of the preceding claims, **characterized in that** the circuit components which can be activated or deactivated selectively comprise in each case all the elements of one or more scan chains (S1-Sn).

7. Method according to one of Claims 1 to 5, **characterized in that** the circuit components which can be activated or deactivated selectively comprise selected components of one or more scan chains (S1-Sn).

8. Method according to one of Claims 4 and 5-7, when related to Claim 4, **characterized in that** whether a normal clock signal (CLKI-CLKn), the specific test clock signal (TCLK) or no clock signal is applied to the relevant circuit components is made dependent on the contents of one or more registers (SCANSELREG) assigned to circuit components and on the status of a mode-of-operation-selection signal (TES).

9. Method according to one of the preceding claims, **characterized in that** a plurality of test runs is carried out in order to test the circuit to be tested, at least to a certain extent different circuit components being activated on each test run.

10. Method according to Claim 9, **characterized in that** the number of test runs carried out is such that ultimately each of the circuit components to be tested has been activated at least once alone or together with other circuit components.

11. Method according to Claim 10, **characterized in that** the initial states in which the circuit components are placed before each run are identical for the various test runs.

12. Method according to one of Claims 8 to 11, **characterized in that** the contents of the register (SCANSELREG) are changed as a function of circuit-specific presettings and the number of the test run.

## Revendications

1. Procédé en vue de tester un montage électronique, dans lequel l'état réel de parties de montage mises en service auparavant du point de vue du test après une initialisation initiale est comparé à un état de consigne, le montage à tester étant mis dans un mode de fonctionnement de balayage, dans lequel les éléments (FF1-1 - FFn-n) dont l'état doit être initialisé ou extrait sont câblés les uns derrière les autres en une ou plusieurs chaînes de balayage (S1 - Sn), en vue d'initialiser et de déterminer l'état réel,
**caractérisé en ce**
**qu'**essentiellement seules les parties de montage parmi lesquelles une coopération conforme peut être attendue dans les circonstances données sont à chaque fois simultanément exploitées et non l'ensemble des parties de montage parmi les parties de montage à tester.

2. Procédé selon la revendication 1,
**caractérisé en ce**
**que** la distribution des éléments de chaînes de balayage (FF1-1 - FFn-n) sur les différentes chaînes de balayage (S1 - Sn) et/ou la détermination de l'ordre au sein d'une chaîne de balayage est effectuée de sorte que des signaux de synchronisation (TCLK) par lesquels les éléments de chaînes de balayage sont synchronisés atteignent les éléments de chaînes de balayage pendant le test au plus tard à un moment auquel des signaux doivent être reçus et/ou envoyés par l'élément de chaîne de balayage respectif.

3. Procédé selon la revendication 1 ou 2,
**caractérisé en ce**
**qu'**au moins des parties de bascules du montage à tester sont utilisées en tant qu'éléments de chaînes de balayage (FF1-1 - FFn-n).

4. Procédé selon l'une quelconque des revendications précédentes,
**caractérisé en ce**
**qu'**un signal de synchronisation de test spécial est utilisé en tant que signal de synchronisation (TCLK) en vue de l'initialisation, en vue de la mise en service du point de vue du test et en vue de l'extraction des états du montage à tester.

5. Procédé selon l'une quelconque des revendications précédentes,
**caractérisé en ce**
**qu'**aucun signal de synchronisation n'est acheminé aux parties du montage à tester qui ne doivent pas être initialisées, mises en service du point de vue du test ou extraites au moment concerné.

6. Procédé selon l'une quelconque des revendications précédentes,
**caractérisé en ce**
**que** les parties de montage qui peuvent être mises en service ou hors service de manière sélective comprennent à chaque fois l'ensemble des éléments d'une ou de plusieurs chaînes de balayage (S1 - Sn).

7. Procédé selon l'une quelconque des revendications 1 à 5,
**caractérisé en ce**
**que** les parties de montage qui peuvent être mises en service ou hors service de manière sélective comprennent des parties sélectionnées d'une ou de plusieurs chaînes de balayage (S1 - Sn).

8. Procédé selon l'une quelconque des revendications 4 et 5 à 7, lorsqu'elles se rapportent à la revendication 4,
**caractérisé en ce**
**qu'**il dépend du contenu d'un ou de plusieurs registres attribués aux parties de montage (SCANSELREG) et de l'état d'un signal de sélection de mode de fonctionnement (TES) si un signal de synchronisation normal (CLK1 - CLKn), le signal de synchronisation de test spécial (TCLK) ou aucun signal de synchronisation (n')est appliqué aux parties de montage concernées.

9. Procédé selon l'une quelconque des revendications précédentes,
**caractérisé en ce**
**que** plusieurs passages de test sont effectués en vue de tester le montage à tester, au moins d'autres parties de montage étant partiellement mises en service à chaque passage de test.

10. Procédé selon la revendication 9,
**caractérisé en ce**
**qu'**autant de passages de test sont effectués que finalement chacune des parties de montage à tester a été mise en service au moins une fois seule ou ensemble avec d'autres parties de montage.

11. Procédé selon la revendication 10,
**caractérisé en ce**
**que** les états initiaux dans lesquels les parties de montage sont mises avant chaque passage sont identiques dans les différents passages de test.

12. Procédé selon l'une quelconque des revendications 8 à 11,
**caractérisé en ce**
**que** le contenu du registre (SCANSELREG) est modifié en fonction de préréglages spécifiques au montage et du nombre de passages de test.
